# EUROPEAN PATENT APPLICATION

(11) **EP 4 012 712 A1**
(43) Date of publication of application: **15.06.2022**
(21) Application number: 19942369.0
(22) Date of filing: 21.08.2019
(51) Int. Cl.: G11C 29/08

(54) **TEST CIRCUIT OF MEMORY AND DEVICE**

(71) Applicant: Huawei Technologies Co., Ltd., Longgang District Shenzhen, Guangdong 518129 (CN)
(72) Inventor: XU, Tuanhui, Shenzhen, Guangdong 518129 (CN)
(74) Representative: Thun, Clemens
(86) International application number: PCT/CN2019/101781
(87) International publication number: WO 2021/031149

(57) **Abstract**

This application provides a memory test circuit and an apparatus, and relates to the field of chip technologies, to resolve prior-art test problems of excessively high area overheads of a memory built-in self-test circuit and difficulty in implementing simultaneous read/write operations on a plurality of ports. The test circuit includes a test controller (301) and an address signal converter (302). The test controller (301) is configured to generate a test address and write test data into a memory (303). The address signal converter (302) is configured to receive the test address, convert the test address into a plurality of storage addresses of the test data in the memory (303), and input the plurality of storage addresses into a plurality of address input ports of the memory (303). The test controller (301) is further configured to read data from the plurality of storage addresses and generate a test result based on the read data.

## Description

### TECHNICAL FIELD

This application relates to the field of chip technologies, and in particular, to a memory test circuit and an apparatus.

### BACKGROUND

With the increasingly wide application of multi-processor computing systems, a multi-port static random access memory (Static Random-Access Memory, SRAM) plays a very important role when a processor needs to simultaneously initiate a plurality of read/write operations. During chip manufacturing, some chips may be physically defective due to a manufacturing process problem. For example, some lines of a read/write control circuit have a problem such as a short circuit or an open circuit. Therefore, in order to screen out a defective chip, usually the chips need to be tested by using a test circuit. For an SRAM, usually a test is performed by using a memory built-in self-test (Memory built-in self-testing, MBIST) circuit.

To implement the test of the SRAM, in a solution, one set of shared buses (shared buses) may be used for access, to achieve the test of the SRAM. In this solution, an MBIST test circuit needs to be added. During the test, if a plurality of SRAMs need to be tested, each SRAM may be accessed through the shared bus to implement the test. During the test of each SRAM, an existing shared bus can achieve read/write access to only one set of ports (ports) of one SRAM at a time. A common SRAM does not support simultaneous write operations from a plurality of ports (two or more write ports) on one address. If the shared bus is expanded to achieve access to at least two addresses, consequently an area of the MBIST test circuit is excessively large, and a circuit production process is difficult to implement. In addition, central processing unit (Central Processing Unit, CPU) performance is severely affected. In another solution, a selector may be added to an input end of the memory to select between an input signal of a normal function and an input signal for a test. The input signal for the test comes from a test controller. In this solution, a read/write test can be performed on only one set of ports of the memory at a time. However, if a read/write test needs to be performed simultaneously on a plurality of ports, a plurality of test controllers need to be added. Consequently, area overheads of the test circuit are excessively high, and the test circuit is difficult to physically implement.

### SUMMARY

This application provides a memory test circuit and an apparatus, to resolve prior-art test problems of excessively high area overheads of a memory built-in self-test circuit and difficulty in implementing simultaneous read/write operations on a plurality of ports.

To achieve the foregoing objective, this application uses the following technical solutions.

According to a first aspect, a test circuit for a memory is provided. The test circuit includes a test controller and an address signal converter. The test controller is configured to generate a test address and write test data into a memory. The address signal converter is configured to receive the test address, convert the test address into a plurality of storage addresses of the test data in the memory, and input the plurality of storage addresses into a plurality of address input ports of the memory. The test controller is further configured to read data from the plurality of storage addresses and generate a test result based on the read data.

In this embodiment of this application, the address signal converter is disposed at a periphery of the memory, so that the test address generated by the test controller canbe converted into the plurality of storage addresses, and the plurality of storage addresses are input to the plurality of address input ports of the memory. The test controller determines the test result based on the data read by the memory. The test circuit may be an MBIST test circuit, so as to implement, by using one MBIST test circuit, a test of simultaneous read/write operations on a plurality of ports of the memory through one set of shared buses (bus), without expanding the shared bus (bus) to test the memory with the plurality of ports, and without adding a plurality of test controllers. This resolves a problem of high overheads caused by expanding the shared bus (bus) or disposing a plurality of test controllers. This improves test efficiency of the MBIST test circuit.

In a possible design, the converting the test address into a plurality of storage addresses of the test data in the memory, and inputting the plurality of storage addresses into a plurality of address input ports of the memory specifically includes: converting the test address into a plurality of write input addresses and/or a plurality of read input addresses, where the plurality of write input addresses are different from each other, and the plurality of read input addresses are different from each other; and inputting the plurality of write input addresses into a plurality of write address input ports of the memory, and inputting the plurality of read input addresses into a plurality of read address input ports of the memory. In the foregoing possible implementation, the address signal converter converts the test address into the plurality of write input addresses and/or the plurality of read input addresses, and respectively inputs them into the plurality of write address input ports and/or the plurality of read address input ports of the memory. Therefore, a test of simultaneous read data operations, simultaneous write data operations, or simultaneous read data and write data operations can be performed on a plurality of ports of the memory through one set of shared buses (bus). This improves test efficiency of the test circuit.

In a possible design, the test circuit further includes a selector, and the selector is configured to select, based on a selection signal output by the test controller, data from the data read from the plurality of storage addresses of the memory and output the selected data. In the foregoing possible implementation, the selector selects the data from the storage data output by the memory and output the selected data, so that simultaneously read data can be sequentially output to the test controller to determine a test result. This improves test efficiency of the test circuit.

In a possible design, the test controller is further configured to generate a read/write control signal, and the test circuit further includes a read/write signal converter. The read/write signal converter is configured to: receive the read/write control signal, and convert the read/write control signal into a plurality of read control signals and/or a plurality of write control signals; and input the plurality of write control signals into a plurality of write control ports of the memory, and input the plurality of read control signals into a plurality of read control ports of the memory. In the foregoing possible implementation, the read/write signal converter converts the read/write control signal generated by the test controller into the plurality of read control signals and/or the plurality of write control signals, which are input into the memory for read/write data control, so as to achieve a test of simultaneous read/write operations on a plurality of ports of the memory. This improves test efficiency of the test circuit.

In a possible design, the test controller is further configured to generate the test data, and the test circuit further includes a data signal converter. The data signal converter is configured to receive the test data, convert the test data into a plurality of pieces of test data, and input the plurality of pieces of test data into a plurality of write data input ports of the memory, and at least two of the plurality of pieces of test data are different from each other. In the foregoing possible implementation, the data signal converter converts the test data generated by the test controller into the plurality of pieces of test data, which are input into the memory for write data control, so as to implement a test of simultaneous write operations on a plurality of ports of the memory. This improves test efficiency of the test circuit.

In a possible design, the test controller is further configured to generate a test mode signal, where the test mode signal includes a multi-port test signal and a single-port test signal. In the foregoing possible implementation, the test mode signal generated by the test controller may be used to select whether to perform a single-port test or a multi-port test by the test circuit. This improves flexibility of the test circuit.

In a possible design, the read/write signal converter is further configured to: when the test mode signal is the multi-port test signal, output the plurality of read control signals and/or the plurality of write control signals output by the read/write signal converter; or when the test mode signal is the single-port test signal, output the read/write control signal generated by the test controller. In the foregoing possible implementation, the read/write signal converter selects, based on the test mode signal generated by the test controller, to output a single read/write control signal or a plurality of read/write control signals, so as to select whether to perform a single-port test or a multi-port test by the test circuit. This improves flexibility of the test circuit.

In a possible design, the address signal converter is further configured to: when the test mode signal is the multi-port test signal, output the plurality of write input addresses and/or the plurality of read input addresses output by the address signal converter; or when the test mode signal is the single-port test signal, output the test address generated by the test controller. In the foregoing possible implementation, the address signal converter selects, based on the test mode signal generated by the test controller, to output a single test address or a plurality of test addresses, so as to select whether to perform a single-port test or a multi-port test by the test circuit. This improves flexibility of the test circuit.

In a possible design, the data signal converter is further configured to: when the test mode signal is the multi-port test signal, output the plurality of pieces of test data output by the data signal converter; or when the test mode signal is the single-port test signal, output the test data generated by the test controller. In the foregoing possible implementation, the output data signal converter selects, based on the test mode signal generated by the test controller, to output a single piece of test data or a plurality of pieces of test data, so as to select whether to perform a single-port test or a multi-port test by the test circuit. This improves flexibility of the test circuit.

According to a second aspect, a memory test chip is provided. The memory test chip includes the test circuit according to any one of the foregoing possible designs of the first aspect. It can be understood that for beneficial effects that can be achieved by the memory test chip, refer to the beneficial effects of the test circuit provided in the first aspect. Details are not described herein again.

### BRIEF DESCRIPTION OF DRAWINGS

FIG. 1 is a schematic diagram of a memory chip according to an embodiment of this application;
FIG. 2 is a schematic diagram of a structure of a memory test circuit according to an embodiment of this application;
FIG. 3 is a schematic diagram of a structure of another memory test circuit according to an embodiment of this application;
FIG. 4 is a schematic diagram of a structure of still another memory test circuit according to an embodiment of this application;
FIG. 5 is a schematic diagram of a structure of yet another memory test circuit according to an embodiment of this application;
FIG. 6 is a schematic diagram of a structure of still yet another memory test circuit according to an embodiment of this application;
FIG. 7 is a logic circuit diagram of another address signal converter according to an embodiment of this application; and
FIG. 8 is a logic circuit diagram of another data signal converter according to an embodiment of this application.

### DESCRIPTION OF EMBODIMENTS

The following terms "first" and "second" are merely intended for a purpose of description, and shall not be understood as an indication or implication of relative importance or implicit indication of a quantity of indicated technical features. Therefore, a feature defined by "first" or "second" may explicitly or implicitly include one or more features. In the description of embodiments, unless otherwise specified, "a plurality of" means two or more than two.

Before describing the embodiments of this application, the following first describes related technologies.

Static random access memory (Static Random-Access Memory, SRAM): It is a type of random access memory. "Static" means that when such a memory is powered on, storage data can be constantly kept. Compared with a dynamic random access memory (Dynamic Random Access Memory, DRAM), the SRAM does not need to periodically refresh a circuit to save the data stored in it.

Random access memory (Random Access Memory, RAM): It is also referred to as a main memory, and is an internal memory that directly exchanges data with a CPU. Data can be read and written at any time (except for refreshing) at a very high speed, and the RAM is usually used as a temporary data storage medium for an operating system or another running program. During working, the RAM can write (store) or read (obtain) information from any specified address at any time. RAMs are classified into SRAMs and DRAMs based on working principles of memory cells.

Memory built-in self-test (Memory built-in self-testing, MBIST): It is a circuit into which a related test function is implanted during memory chip design to provide a self-test function. This reduces dependence of a device test on automatic test equipment.

Memory: It is a memory device used in an electronic computer to store data, instructions, and the like. It may be a separate chip or integrated with another device. A main function of the memory is to store programs and various data, and the memory can automatically implement access to programs or data at a high speed during operating of the computer. Memory types may include: an SRAM, a RAM, a DRAM, a non-volatile magnetic random access memory (Magnetic Random Access Memory, MRAM), a flash memory (Flash Memory), and the like.

Logic gate: It is a basic component on an integrated circuit. A simple logic gate may include a transistor, so that high and low levels representing two types of signals generate high or low level signals after passing through the logic gate. High and low levels may respectively represent logical "true" and "false", or 1 and 0 in binary, so as to implement logical operations. Common logic gates include AND gates, OR gates, NOT gates, XOR gates, and the like. Logic gates may be combined to implement complex logic operations.

An embodiment of this application provides a memory test circuit. A logic circuit is added to a common memory test circuit structure to implement simultaneous read/write operations on a plurality of ports of a memory, so as to resolve prior-art problems of excessively high area overheads of a memory built-in self-test circuit and difficulty in implementing simultaneous read/write operations on a plurality of ports.

This embodiment of this application may be implemented in a computer device. The memory test circuit may be specifically used for a multi-processor computing system, namely, a computer system that requires a plurality of processors to simultaneously initiate a plurality of data read/write operations on the memory.

First, a structure and principles of a memory chip related to this application are briefly described. In the following embodiments of this application, an SRAM memory is merely used as an example for detailed description, and this does not impose a limitation on this application.

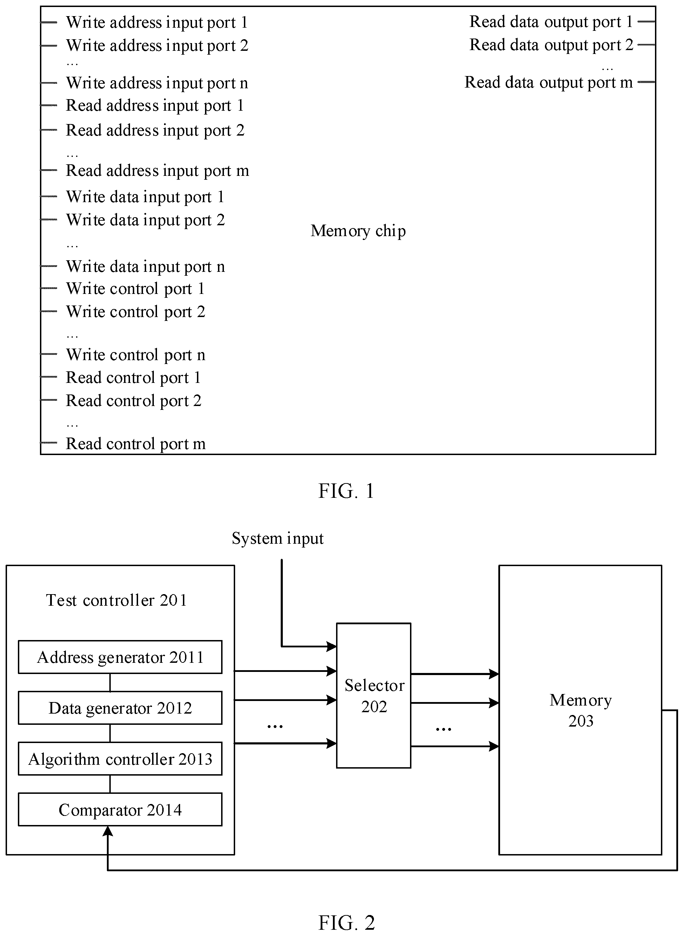

As shown in FIG. 1, a multi-port SRAM memory chip is a memory chip that can simultaneously perform write data operations with a maximum of n ports and read data operations with a maximum of m ports. The memory chip includes a plurality of write address input ports, a plurality of read address input ports, a plurality of write data input ports, a plurality of write control ports, a plurality of read control ports, and a plurality of read data output ports.

Specifically, as shown in FIG. 1, the memory chip includes: a write address input port 1, a write address input port 2, ..., a write address input port n, a read address input port 1, a read address input port 2, ..., a read address input port m, a write data input port 1, a write data input port 2, ..., a write data input port n, a write control port 1, a write control port 2, ..., a write control port n, a read control port 1, a read control port 2, ..., a read control port m, and a read data output port 1, a read data output port 2, ..., a read data output port m.

The write address input port 1, the write address input port 2, ..., the write address input port n may be configured to input a storage address data in the memory chip, which is required by a write operation, which may also be referred to as a write-into address. A bit width of the write-into address may be determined by a bit width of a memory cell of the memory chip.

The read address input port 1, the read address input port 2, ..., the read address input port m may be configured to input a storage address of data in the memory chip, which is required by a read operation, which may also be referred to as a read address. Abit width of the read address may be determined by the bit width of the memory cell of the memory chip.

The write data input port 1, the write data input port 2, ..., the write data input port n may be configured to input, into the memory cell of the memory chip, storage data requiring a write operation, which may also be referred to as write-into data.

The write control port 1, the write control port 2, ..., the write control port n may be configured to input a write control signal requiring a write operation, which may also be referred to as a write enable signal. The write control signal input by the write control port may be used to control a data storage operation on the write data input port of the memory.

The read control port 1, the read control port 2, ..., the read control port m may be configured to input a read control signal requiring a read operation, which may also be referred to as a read enable signal. The read control signal input by the read control port may be used to control an operation on the read data output port of the memory.

The read data output port 1, the read data output port 2, ..., the read data output port m may be configured to output storage data that requires a read operation and that is in the memory cell corresponding to the foregoing read address, which may also be referred to as read data. The read data is determined by the storage data previously written into the memory cell.

Further, read and write operations can be simultaneously performed on the multi-port SRAM memory because a plurality of sets of read/write circuits are used inside the memory chip to simultaneously control the read and write operations on the memory cell. For example, the write address input port 1, the write data input port 1, and the write control port 1 are electrically connected to a set of write control circuits inside the memory chip, and may be configured to perform a write data operation by using a gating circuit. The read address input port 2, the read data output port 2, and the read control port 2 are electrically connected to a set of read control circuits inside the memory chip, and may be configured to perform a read data operation by using a gating circuit.

In this embodiment of this application, to ensure that a plurality of different pieces of storage data are not written into a same storage address to cause abnormal operating of the memory chip, it may be designed that during simultaneous write operations on a plurality of ports, write addresses of the plurality of ports are different from each other.

In this embodiment of this application, when simultaneous read and write operations are performed on the multi-port SRAM memory, write addresses of a plurality of ports and read addresses of the plurality of ports are different from each other, so as to avoid simultaneous read and write operations on a same storage address to cause the memory chip to work abnormally.

To be specific, for a common port, the SRAM memory does not support simultaneous write operations from a plurality of ports on a same write address, and also does not support simultaneous write and read operations from a plurality of ports on a same address. Therefore, in this embodiment of this application, for a test of the multi-port SRAM memory, occurrence of the foregoing two abnormalities is avoided.

As shown in FIG. 1 with reference to Table 1 below, an internal circuit structure of the multi-port SRAM memory chip may be the following symmetric structure, including a bit cell array for storing data and a peripheral logic circuit. The peripheral logic circuit may include a sense amplifier, a row/column decoder, an input/output latch, a read/write circuit, and the like.

**Table 1**

| Memory cell array | Row address decoder | Memory cell array |
|---|---|---|
| Sense amplifier | Time sequence control circuit | Sense amplifier |
| Column address decoder | | Column address decoder |
| Read/write control circuit | | Read/write control circuit |
| Input/output latch | | Input/output latch |

The memory cell array (Bit Cell Array) includes a large quantity of memory cells, usually memory cells are arranged in a form of an N-row × M-column matrix, and each memory cell can store 1-bit binary data (0, 1). For example, an SRAM includes a 128×8×16 memory cell array. To be specific, the memory includes a bit cell array with a depth of 128 and a bit width of 8×16, and has 128×128 memory cells.

Time sequence control circuit (Control and Clock Tree): is driven by clock signals to control input and output signals of a logic circuit on the memory chip. The sense amplifier (Sense Amplifier) is used to compare a difference between two input signals and amplify the difference. Because the SRAM chip with the symmetric structure is implemented by using a differential circuit structure, that is, a difference between two signals is used to represent that an output value of the signal is 0 or 1. The sense amplifier may amplify an input signal with a relatively small difference, to determine an output signal.

Row/column address decoder (Row/Column Decoder): is configured to position a specific bit cell array based on an input address. Specifically, the row address decoder outputs a row selection signal, the column address decoder outputs a column address selection signal, and an intersection of a row selection line and a column selection line is a selected memory cell array.

Read and write control circuit (Read and Write Circuit): processes a read command or a write command output by a central processing unit, and generates a corresponding read control signal (read enable signal) or a write control signal (write enable signal) with reference to a row/column selection signal output by the row/column address decoder, to determine whether to perform a read operation or a write operation on a memory cell array positioned by the row/column selection signal. When the read enable signal is valid, it indicates that a read operation is performed on the memory cell array, and when the write enable signal is valid, it indicates that a write operation is performed on the memory cell array.

Input/output latch (Input Output Latch): The latch maintains a particular level state to temporarily save a signal, and is used to temporarily save an input or output signal.

A read/write operation principle of the memory chip is specifically as follows: Each memory cell in a memory array shares electrical connections with other cells in rows and columns. By performing row/column address decoding on an input address, a specific row selection line and column selection line can be selected, and an intersection of the row selection line and the column selection line is a selected memory cell. Each memory cell is uniquely selected according to this method. Then, a read operation or a write operation is performed on the selected memory cell according to a read control signal or a write control signal. Some memories are designed so that a plurality of bits of data, such as 4 bits or 8 bits, are input and output at the same time. In this case, four or eight memory cells are selected at the same time according to the method above, and simultaneous read/write operations are performed on a plurality of ports.

Based on the foregoing memory chip, the MBIST test circuit is configured to perform a circuit fault test on a storage function when simultaneous read/write operations are performed on the plurality of ports of the memory chip, so as to discover a short circuit fault, an open circuit fault, or another possible concurrent coupling fault that may be caused in a manufacturing process of the memory chip. Usually, the MBIST test circuit may be designed based on the original memory chip, and a peripheral logic circuit is constructed to test a memory 203. As shown in FIG. 2, the MBIST test circuit may include a test controller 201 and a selector 202.

The selector 202 is configured to select, based on a selection signal of a system, a storage signal of a normal function that is input by the system, to control the memory 203 to store data, or a test signal input by the test controller 201 to control the memory 203 to perform a function test.

The test controller 201 is configured to output a test control signal, receive test return data, and implement a function test on the memory 203 to output a test result. As shown in Table 2, the test control signal of the test controller 201 may include the following.

**Table 2**

| Signal type | Signal name | Signal function |
|---|---|---|
| Output signal | Mode control signal | Is used to control a circuit to enter a normal function mode or enter a test mode. |
| | Storage address group | Indicates that memories of a same module are classified into one group. Physical locations of memories in a same group are close to each other. |
| | Test address | Indicates a storage address index of a memory. |
| | Read-test address | Is used to indicate a read operation address of a read port. |
| | Test data | Indicates a data value written by a write operation. It is recommended that a width of input data is not less than a bit width of a memory. |
| | Read control signal | Enables a read data operation. |
| | Write control signal | Enables a write data operation. |
| | Bit mask (Bit mask) | Is used to set a specific bit of an input address of a memory not to undergo a write operation. |
| | Reset signal | When this signal is valid, a register with a reset function inside a memory can be reset. |
| Input signal | Test return data | Is used to output data stored at a read storage address during a read operation. |

Further, the test controller 201 is configured to output the test control signal, compare test return data received from the memory 203 with an expected value after a read/write data operation is performed on the memory 203, and determine and output a test result.

As shown in FIG. 2, an internal structure of the test controller 201 may include an address generator 2011, a data generator 2012, an algorithm controller 2013, and a comparator 2014.

The address generator 2011 is configured to generate different test addresses to test different memory cells of the memory 203. The data generator 2012 is configured to generate test data to be written into the test address. The algorithm controller 2013 is configured to generate a read/write control signal for controlling a read/write operation. The comparator 2014 is configured to compare a test return signal of the memory 203 with expected data generated by the test controller 201, and determine, based on a comparison result, whether the test data passes the test. For example, a signal 1 may be output if the test is passed, or a signal 0 may be output if the test is not passed.

An embodiment of this application provides a memory test circuit. Based on the foregoing structure of the MBIST test circuit, a signal conversion circuit is added to a periphery of a memory chip, to implement simultaneous read/write operations on a plurality of ports, that is, to implement a write operation test simultaneously performed on different storage addresses of a plurality of ports, a read operation test simultaneously performed on different storage addresses of a plurality of ports, and a read operation and write operation test simultaneously performed on different storage addresses of a plurality of ports. Therefore, this covers possible physical defects when the SRAM performs multi-port simultaneous read/write operations, and resolves a prior-art problem of excessively high area overheads of the MBIST test circuit.

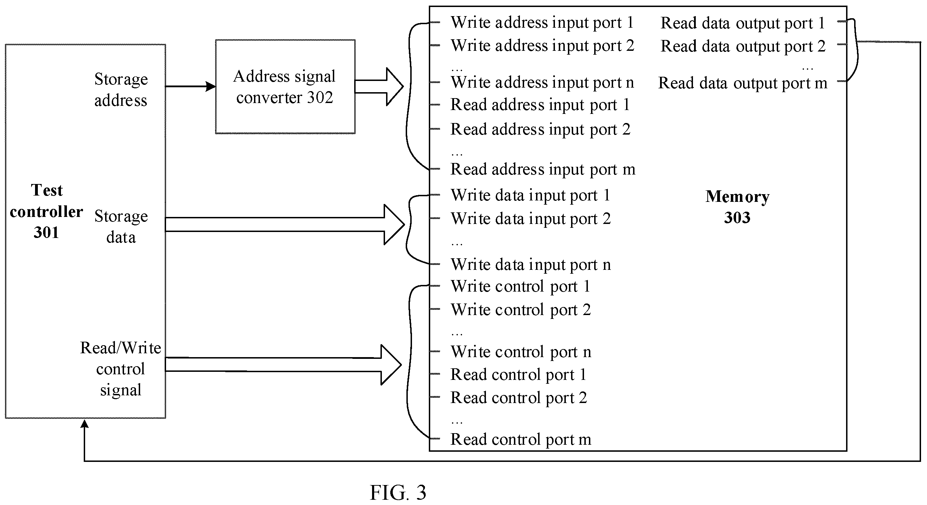

As shown in FIG. 3, the memory test circuit may include a test controller 301 and an address signal converter 302, to test a memory 303. Connection relationships of the memory test circuit may be as follows: A plurality of output ports of the test controller 301 are connected to a plurality of input ports of the address signal converter 302, a plurality of output ports of the address signal converter 302 are connected to a plurality of input ports of the memory 303, and an output port of the memory 303 returns a test signal and is connected to an input port of the test controller 301.

The address signal converter 302 is configured to receive a test address output by the test controller 301, convert the test address into a plurality of storage addresses of test data in the memory, and input the plurality of storage addresses into the plurality of address input ports of the memory 303.

Further, the address signal converter 302 is configured to convert one test address into a plurality of write input addresses and a plurality of read input addresses through decoding processing, where the plurality of write input addresses are different from each other, and the plurality of read input addresses are different from each other. For example, the memory 303 is designed to have seven write address input ports and 12 read address input ports. The address signal converter may perform address decoding and conversion processing on an input test address (Address_in) to generate seven different storage addresses for a write operation and 12 storage addresses for a read operation.

In practical circuit design, the address signal converter may be implemented by combining logic gate devices such as AND gates, OR gates, NOT gates, and XOR gates. The address decoding function can be implemented as long as a logic circuit can generate a plurality of different storage addresses by using one input address. A specific design of the logic circuit of the address signal converter is not limited in this embodiment of this application.

For example, when the test controller outputs a write control signal and outputs a test address 0000000 for performing a write operation test, the address signal converter may be designed to output a plurality of different storage addresses 1 to 19 after conversion of the input test address 0000000 by the logic circuit. The storage address 1 to the storage address 7 may be respectively input into a write address input port 1 to a write address input port 7 of the memory 303. In this embodiment, a prerequisite is that a quantity n of write address input ports of the memory 303 is greater than or equal to 7. The storage address 8 to the storage address 19 may be respectively input into a read address input port 1 to a read address input port 19 of the memory 303. In this embodiment, a prerequisite is that a quantity m of read address input ports of the memory 303 is greater than or equal to 12.

The seven storage addresses input into the write address input ports may be as follows:
A storage address 1 input into the write address input port 1 is 0000000.
A storage address 2 input into the write address input port 2 is 0000001.
A storage address 3 input into the write address input port 3 is 0000010.
A storage address 4 input into the write address input port 4 is 0000011.
A storage address 5 input into the write address input port 5 is 0000100.
A storage address 6 input into the write address input port 6 is 0000101.
A storage address 7 input into the write address input port 7 is 0000110.

The 12 storage addresses input into the read address input ports may be as follows:
A storage address 8 input into the read address input port 1 is 1000000.
A storage address 9 input into the read address input port 2 is 1000001.
A storage address 10 input into the read address input port 3 is 1000010.
A storage address 11 input into the read address input port 4 is 1000011.
A storage address 12 input into the read address input port 5 is 1000100.
A storage address 13 input into the read address input port 6 is 1000101.
A storage address 14 input into the read address input port 7 is 1000110.
A storage address 15 input into the read address input port 8 is 1000111.
A storage address 16 input into the read address input port 9 is 1001000.
A storage address 17 input into the read address input port 10 is 1001001.
A storage address 18 input into the read address input port 11 is 1001010.
A storage address 19 input into the read address input port 12 is 1001011.

Further, when the test controller outputs a read control signal and outputs a test address 0000000 for performing a read operation test, the address signal converter may be designed to output a plurality of different storage addresses 1 to 19 after conversion of the input test address 0000000 by a circuit. The storage address 1 to the storage address 12 may be respectively input into a read address input port 1 to a read address input port 12 of the memory 303. The storage address 13 to the storage address 19 may be respectively input into a write address input port 1 to a write address input port 7 of the memory 303. In this embodiment, a prerequisite is that a quantity n of write address input ports of the memory 303 is greater than or equal to 7, and a quantity m of read address input ports is greater than or equal to 12.

The 12 storage addresses input into the read address input ports may be as follows:
A storage address 1 input into the read address input port 1 is 0000000.
A storage address 2 input into the read address input port 2 is 0000001.
A storage address 3 input into the read address input port 3 is 0000010.
A storage address 4 input into the read address input port 4 is 0000011.
A storage address 5 input into the read address input port 5 is 0000100.
A storage address 6 input into the read address input port 6 is 0000101.
A storage address 7 input into the read address input port 7 is 0000110.
A storage address 8 input into the read address input port 8 is 0000111.
A storage address 9 input into the read address input port 9 is 0001000.
A storage address 10 input into the read address input port 10 is 0001001.
A storage address 11 input into the read address input port 12 is 0001010.
A storage address 12 input into the read address input port 12 is 0001011.

The seven storage addresses input into the write address input ports may be as follows:
A storage address 13 input into the write address input port 1 is 1000000.
A storage address 14 input into the write address input port 2 is 1000001.
A storage address 15 input into the write address input port 3 is 1000010.
A storage address 16 input into the write address input port 4 is 1000011.
A storage address 17 input into the write address input port 5 is 1000100.
A storage address 18 input into the write address input port 6 is 1000101.
A storage address 19 input into the write address input port 7 is 1000110.

The foregoing embodiment merely provides an example of an address conversion manner of the address signal converter 302 that is relatively easy to implement. There may be another design, so that the test address output by the test controller is converted into a plurality of different storage addresses, to implement the foregoing technical solutions of this embodiment of this application.

In the foregoing implementation, during an MBIST test, a single-port test control circuit may be used to implement a test of simultaneous read/write operations on a plurality of ports of the memory, so as to detect whether a fault exists in an internal logic circuit of the memory. This reduces test circuit overheads. In addition, in this implementation, a plurality of read data or write data operations are not performed on a same storage address at the same time, and a read/write conflict does not occur in the memory.

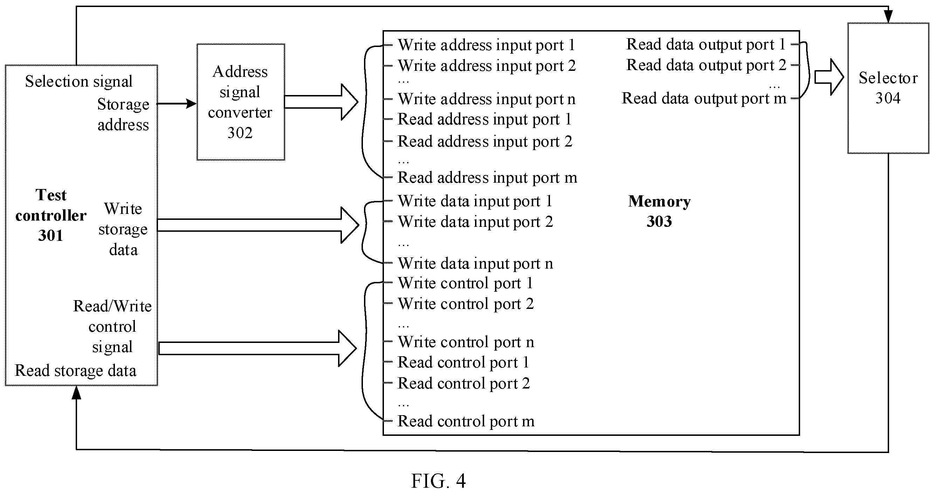

Further, the memory test circuit may further include a selector 304. As shown in FIG. 4, a port, for outputting a selection signal (port_select), of the test controller 301 is connected to an input port of the selector 304. A plurality of read data output ports of the memory 303 are connected to a plurality of input ports of the selector 304. An output port of the selector 304 is connected to an input port of the test controller 301, and specifically, may be connected to a comparator of the test controller 301.

The selector 304 is configured to select, based on the selection signal (port select) output by the test controller 301, data from the data read from the plurality of storage addresses of the memory 303 and output the selected data.

Specifically, the selector 304 may select to sequentially output a plurality of pieces of data read from the memory, or select only storage data, needing to be compared, of the read data output port each time to input the data into the test controller 301 for comparison. For example, the selector 304 sequentially outputs storage data output by a read data output port 1, a read data output port 2, ..., a read data output port m of the memory 303.

In addition, the storage data output by the selector 304 is returned to the test controller 301. The comparator of the test controller 301 compares the storage data with expected data generated by the test controller 301, and determines, based on a comparison result, whether the test data passes a test, to obtain a test result.

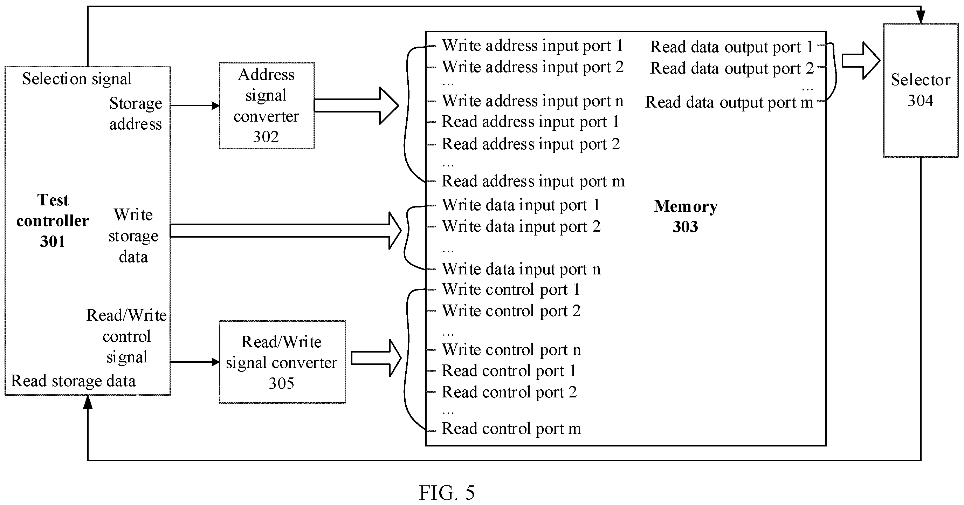

Further, as shown in FIG. 5, the memory test circuit may further include a read/write signal converter 305. The read/write signal converter 305 is configured to receive a read/write control signal generated by the test controller 301, convert the read/write control signal into a plurality of read control signals and/or a plurality of write control signals, and input the plurality of write control signals into a plurality of write control ports of the memory 303, and the plurality of read control signals into a plurality of read control ports of the memory 303.

For example, the test controller 301 outputs one read control signal to the read/write signal converter 305, and the read/write signal converter 305 may output a plurality of read control signals 1 to m and a plurality of write control signals 1 to n. Output ports of the read/write signal converter 305 are respectively connected to read control ports 1 to m and write control ports 1 to n of the memory 303.

In practical circuit design, the read/write signal converter 305 may be implemented by combining logic gate devices such as AND gates, OR gates, NOT gates, and XOR gates. The read/write signal conversion function can be implemented as long as a logic circuit can convert one read control signal or a write control signal into a plurality of read control signals and a plurality of write control signals. A specific design of the logic circuit of the read/write signal converter is not limited in this embodiment of this application.

In the foregoing implementation, during an MBIST test, a single-port test control circuit may be used to implement a test of simultaneous read/write operations on a plurality of ports of the memory, so as to detect whether a fault exists in an internal logic circuit of the memory. This reduces test circuit overheads. In addition, in this implementation, a plurality of read data or write data operations are not performed on a same storage address at the same time, and a read/write conflict does not occur in the memory.

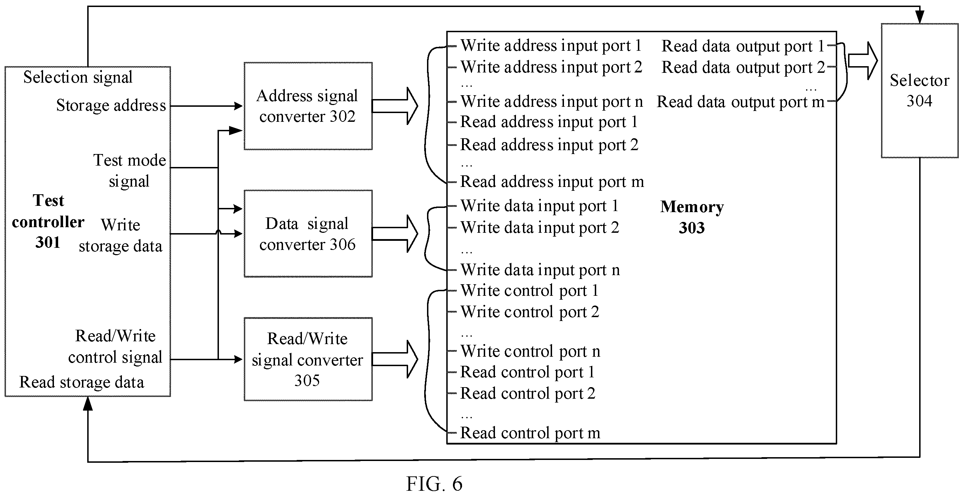

In a possible implementation, as shown in FIG. 6, the memory test circuit may further include a data signal converter 306, configured to receive test data output by the test controller 301, convert the test data into a plurality of pieces of test data, and respectively input the plurality of pieces of test data into a plurality of write data input ports 1 to n of the memory 303. At least two of the plurality of pieces of test data are different from each other.

Specifically, the data signal converter 306 may generate a plurality of different pieces of test data. For example, adjacent pieces of test data are different from each other. In this way, it may be tested whether adjacent data signal lines in the memory have a short circuit, an open circuit, or a concurrent coupling fault.

In practical circuit design, the data signal converter 306 may be implemented by combining logic gate devices such as AND gates, OR gates, NOT gates, and XOR gates. The data signal conversion function can be implemented as long as a logic circuit can convert one piece of input test data into a plurality of pieces of test data. A specific design of the logic circuit of the data signal converter is not limited in this embodiment of this application.

Further, each bit of the test data is converted by the data converter 306, the obtained plurality of pieces of test data are input into the plurality of write data input ports of the memory 303, and test data input into adjacent write data input ports may be set to be different, so as to test a storage function of the memory 303 based on whether output data is correct.

Further, as shown in FIG. 6, the test controller 301 is further configured to output a test mode signal (Test_mode), where the test mode signal may include a multi-port test signal and a single-port test signal. The multi-port test signal is used to indicate to perform a test of multi-port simultaneous read/write operations, and the single-port test signal is used to indicate to perform a test of a single-port read/write data operation.

Specifically, when the test mode signal (Test mode) indicates the multi-port test signal, the read/write signal converter outputs the plurality of read control signals and/or the plurality of write control signals that are generated after read/write signal conversion. When the test mode signal (Test mode) indicates the single-port test signal, the read/write signal converter outputs the read/write control signal output by the test controller.

Specifically, when the test mode signal (Test mode) indicates the multi-port test signal, the address signal converter outputs the plurality of different write input addresses and/or the plurality of read input addresses that are generated after address signal conversion. When the test mode signal (Test mode) indicates the single-port test signal, the address signal converter outputs the test address output by the test controller.

Specifically, when the test mode signal (Test mode) indicates the multi-port test signal, the data signal converter outputs the plurality of pieces of test data generated after data signal conversion. When the test mode signal (Test_mode) indicates the single-port test signal, the data signal converter outputs the test data output by the test controller.

In the foregoing implementation, during an MBIST test, a single-port test control circuit may be used to implement a test of simultaneous read/write operations on a plurality of ports of the memory, and one set of read/write data control signals are converted into a plurality of sets of read/write data control signals, so as to detect whether a fault exists in a control circuit for simultaneous read/write operations inside the memory. This reduces test circuit overheads.

An overall test process of the foregoing test circuit used for the memory in this embodiment of this application is described below by using a specific example.

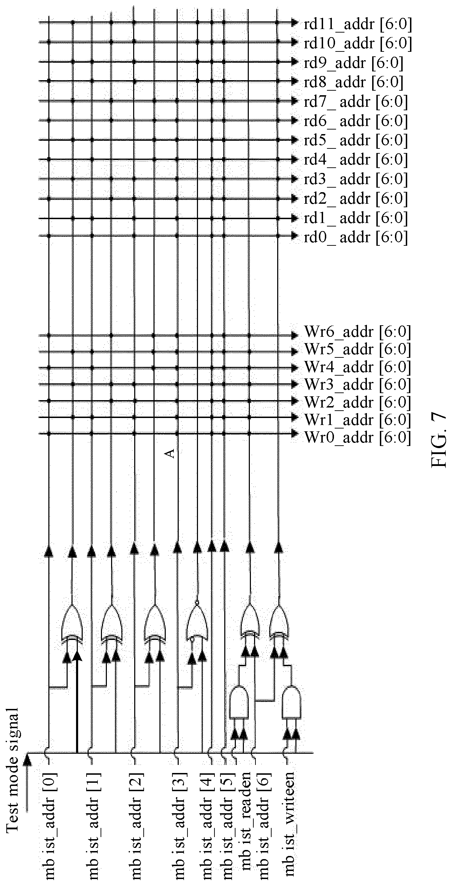

With reference to FIG. 6 and FIG. 7, the test controller outputs a test mode signal (Test mode). For example, when the test mode signal includes a multi-port test signal, that is, Test mode is 1, the memory test circuit performs a test of multi-port simultaneous read/write operations; or when the test mode signal includes a single-port test signal, that is, Test mode is 0, the memory test circuit performs a test of a single-port read/write operation.

The address signal converter may be a circuit structure shown in FIG. 7. For example, a test address mbist_addr input into the address signal converter is 0000000, a bit width of the test address is 7 bits, and each bit of the address may be represented by mbist_addr[i]. XOR gates or AND gates are disposed and combined for some signal lines of seven signal lines of the test address, to obtain mutually different storage addresses 1 to 7 for write operations, which are represented by wrn addr[0:6]. In addition, a negation operation is performed on a most significant bit of the seven signal lines of the test address, namely, the storage address [6], to obtain mutually different storage addresses 8 to 19 for read operations, which are represented by rdm_addr[0:6].

The XOR gate is a logic gate that implements an "exclusive OR" operation in a digital logic circuit. When two input levels are different, the XOR gate outputs a high level (logic 1). If two input levels are the same, the XOR gate outputs a low level (logic 1). The AND gate is a logic gate that implements an "AND" operation. When two input levels are both high levels (logic 1), the AND gate outputs a high level (logic 1); otherwise, the AND gate outputs a low level (logic 0).

It should be noted that, in FIG. 7, a black dot indicates that a circuit is gated, and another signal line cross point indicates that a circuit at this location is not connected. Because the input test address is 7-bit, there are seven signal lines. It can be understood that each black dot on the storage address 1 to the storage address 19 output by the address signal converter implies that this dot exists on a signal line of the storage address, for example, wr0_addr[3], which is shown as A in the figure. The address signal lines implied by these black dots form a 7-bit access address of the storage address.

For example, as shown in FIG. 7, when the test mode signal Test_mode is 1 and the storage address mbist_addr is 0000000, obtained storage addresses are as follows: wr0_addr[0:6] is 0000000, wr1_addr[0:6] is 0000001, wr2_addr[0:6] is 0000010, wr3_addr[0:6] is 0000011, wr4_addr[0:6] is 0000100, wr5_addr[0:6] is 0000101, wr6_addr[0:6] is 0000110, rd0_addr[0:6] is 1000000, rd1_addr[0:6] is 1000001, rd2_addr[0:6] is 1000010, rd3_addr[0:6] is 1000011, rd4_addr[0:6] is 1000100, rd5_addr[0:6] is 1000101, rd6_addr[0:6] is 1000110, rd7_addr[0:6] is 1000111, rd8_addr[0:6] is 1001000, rd9_addr[0:6] is 1001001, rd10_addr[0:6] is 1001010, and rd11_addr[0:6] is 1001011.

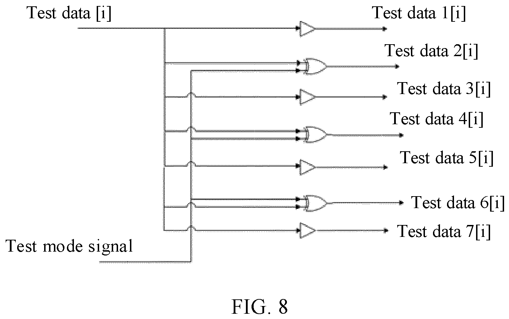

Further, the data converter may be of a circuit structure shown in FIG. 8, and one bit of the test data, for example, an i^{th} bit of the test data, namely, test data [i], is used as an example. Logic circuits of XOR gates or buffer gates are disposed and combined, to obtain the i^{th}-bit data of the seven pieces of test data. Test data 1[i] to test data 7[i] are respectively input into write data input ports 1 to 7 of the memory.

A function of the buffer gate is to identify and buffer an input signal. A level output by the buffer gate is the same as a level input into the buffer gate. To be specific, if a level input into the buffer gate is a high level (logic 1), the buffer gate still outputs a high level (logic 1). If a level input into the buffer gate is a low level (logic 0), the buffer gate still outputs a low level (logic 0).

Therefore, with reference to the circuit shown in FIG. 8, it can be learned that when the input test data [i] is 1 and the test mode signal Test mode is 1, the test data 1[i] is 1, the test data 2[i] is 0 (for an XOR gate, if two identical levels are input, a low level 0 is output), the test data 3 [i] is 1, the test data 4[i] is 0, the test data 5[i] is 1, the test data 6[i] is 0, and the test data 7[i] is 1. In this case, for the i^{th} bit of the output test data, two adjacent pieces of data are different from each other. Similarly, if the test data [i] is 0 and the test mode signal Test mode is 1, it can be learned from FIG. 8 that the output test data 1[i] is 0, the test data 2[i] is 1 (for an XOR gate, if two different levels are input, a high/low level 1 is output), the test data 3[i] is 0, the test data 4[i] is 1, the test data 5[i] is 0, the test data 6[i] is 1, and the test data 7[i] is 0. Two adjacent pieces of data are still different.

Further, the read/write signal converter may convert one read/write control signal output by the test controller into seven write control signals (write enable signals) and 12 read control signals (read enable signals). The seven write control signals (write enable signals) are respectively input into write control ports 1 to 7 of the memory chip, and the 12 read control signals (read enable signals) are respectively input into read control ports 1 to 12.

Based on the foregoing input signals, the memory chip uses an internal clock driving circuit to drive seven sets of write control circuits to perform data storage operations, and drive 12 sets of read control circuits to perform data storage output operations. The read data output port 1 to the read data output port 12 of the memory chip respectively output the storage data, from which data is sequentially selected and output by using a selector, and the selected data is returned to the test controller for comparison of the test data, so as to generate a test result.

In the foregoing implementation, during an MBIST test, a single-port test control circuit may be used to implement a test of simultaneous read/write operations on a plurality of ports of the memory, and one set of read/write data control signals are converted into a plurality of sets of read/write data control signals, so as to detect whether a fault exists in a control circuit for simultaneous read/write operations on a plurality of ports inside the memory. This reduces test circuit overheads.

An embodiment of this application further provides a memory test chip. The memory test chip may include any possible design of the foregoing test circuit, and the memory test chip may be configured to implement functions that can be implemented by the foregoing test circuit, so as to implement a test on a control circuit for simultaneous read/write operations on a plurality of ports of a memory. This reduces circuit area overheads for a test on a plurality of ports of the memory.

In the embodiments provided in this application, it should be understood that the disclosed circuit and chip may be implemented in other manners. For example, the test circuit embodiments described above are merely examples. For example, division into the units or devices is merely a logical function division. In actual implementation, another division manner may be available. For example, a plurality of elements or devices may be combined or integrated into another system, or some features may be ignored or not performed. In addition, the displayed or discussed mutual couplings or direct couplings or communication connections may be implemented through some interfaces. The indirect couplings or communication connections between the apparatuses or devices may be implemented in electrical, mechanical or other forms.

The units described as separate parts may or may not be physically separate, and parts displayed as units may or may not be physical units, may be located in one position, or may be distributed on a plurality of network units. Some or all of the units may be selected based on actual requirements to achieve the objectives of the solutions in the embodiments.

In addition, functional units in the embodiments of this application may be integrated into one data processing unit, or each of the units may exist alone physically, or two or more units are integrated into one unit. The integrated unit may be implemented in a form of hardware, or may be implemented in a form of hardware in addition to a software functional unit.

Finally, it should be noted that the foregoing descriptions are merely specific implementations of the embodiments of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. A test circuit for a memory, wherein the test circuit comprises a test controller and an address signal converter; the test controller is configured to generate a test address and write test data into the memory;
the address signal converter is configured to receive the test address, convert the test address into a plurality of storage addresses of the test data in the memory, and input the plurality of storage addresses into a plurality of address input ports of the memory; and
the test controller is further configured to read data from the plurality of storage addresses, and generate a test result based on the read data.

2. The test circuit according to claim 1, wherein the converting the test address into a plurality of storage addresses of the test data in the memory, and inputting the plurality of storage addresses into a plurality of address input ports of the memory specifically comprises:
converting the test address into a plurality of write input addresses and/or a plurality of read input addresses, wherein the plurality of write input addresses are different from each other, and the plurality of read input addresses are different from each other; and
inputting the plurality of write input addresses into a plurality of write address input ports of the memory, and inputting the plurality of read input addresses into a plurality of read address input ports of the memory.

3. The test circuit according to claim 1 or 2, wherein the test circuit further comprises a selector; and
the selector is configured to select, based on a selection signal output by the test controller, data from the data read from the plurality of storage addresses of the memory and output the selected data.

4. The test circuit according to claim 3, wherein the test controller is further configured to generate a read/write control signal, and the test circuit further comprises a read/write signal converter;
the read/write signal converter is configured to: receive the read/write control signal, and convert the read/write control signal into a plurality of read control signals and/or a plurality of write control signals; and
input the plurality of write control signals into a plurality of write control ports of the memory, and input the plurality of read control signals into a plurality of read control ports of the memory.

5. The test circuit according to claim 4, wherein the test controller is further configured to generate the test data, and the test circuit further comprises a data signal converter;
the data signal converter is configured to receive the test data, convert the test data into a plurality of pieces of test data, and input the plurality of pieces of test data into a plurality of write data input ports of the memory; and
at least two of the plurality of pieces of test data are different from each other.

6. The test circuit according to claim 5, wherein the test controller is further configured to generate a test mode signal, wherein the test mode signal comprises a multi-port test signal and a single-port test signal.

7. The test circuit according to claim 6, wherein the read/write signal converter is further configured to:
when the test mode signal is the multi-port test signal, output the plurality of read control signals and/or the plurality of write control signals output by the read/write signal converter; or
when the test mode signal is the single-port test signal, output the read/write control signal generated by the test controller.

8. The test circuit according to claim 6, wherein the address signal converter is further configured to:
when the test mode signal is the multi-port test signal, output the plurality of write input addresses and/or the plurality of read input addresses output by the address signal converter; or
when the test mode signal is the single-port test signal, output the test address generated by the test controller.

9. The test circuit according to claim 6, wherein the data signal converter is further configured to:
when the test mode signal is the multi-port test signal, output the plurality of pieces of test data output by the data signal converter; or
when the test mode signal is the single-port test signal, output the test data generated by the test controller.

10. A memory test chip, wherein the memory test chip comprises the test circuit according to any one of claims 1 to 9.
